# EUROPEAN PATENT APPLICATION

(11) **EP 4 393 605 A1**
(43) Date of publication of application: **03.07.2024**
(21) Application number: 21959061.9
(22) Date of filing: 21.10.2021
(51) Int. Cl.: B05C 5/02

(54) **COATING MACHINE DIE HEAD FLOW ADJUSTING MECHANISM AND WORKING METHOD THEREOF**

(30) Priority: 30.09.2021 CN 202111163226
(71) Applicant: Contemporary Intelligent Manufacturing (Ning De) Co., Ltd, Ningde, Fujian 352100 (CN)
(72) Inventor: NI, Jun, Ningde, Fujian 352100 (CN); XIA, Guangrong, Ningde, Fujian 352100 (CN); ZHU, Siqi, Ningde, Fujian 352100 (CN); MA, Tianxing, Ningde, Fujian 352100 (CN); CHEN, Guanghao, Ningde, Fujian 352100 (CN); QU, Zhibing, Ningde, Fujian 352100 (CN); HUANG, Yunqiang, Ningde, Fujian 352100 (CN); YANG, Zhenbo, Ningde, Fujian 352100 (CN)
(74) Representative: Regimbeau
(86) International application number: PCT/CN2021/125137
(87) International publication number: WO 2023/050497

(57) **Abstract**

A flow adjusting mechanism of a die head of a coater and a working method thereof are provided. The flow adjusting mechanism includes a coarse adjustment mechanism, a fine adjustment mechanism, and a flow choking block which are sequentially arranged from top to bottom. The flow choking block is arranged above a coating slit. A central part of a top surface of the flow choking block is vertically provided with an adjustment rod. The fine adjustment mechanism is connected between the coarse adjustment mechanism and the adjustment rod. The fine adjustment mechanism comprises a vertically arranged piezoelectric actuator. An actuating end of the piezoelectric actuator abuts against a central portion of a top surface of the adjustment rod. The coarse adjustment mechanism includes a first fixed seat. A differential screw assembly is vertically installed on the first fixed seat. A moving end of the differential screw assembly is connected to an upper end of the piezoelectric actuator. The design provided is reasonable; coarse adjustment is achieved through the differential screw structure, and fine adjustment is achieved through the piezoelectric actuator; and coarse adjustment and fine adjustment are combined, such that the flow adjusting accuracy and adjusting efficiency are effectively improved, the coating quality is also stable, and the coating uniformity is improved.

## Description

### TECHNICAL FIELD

The present invention relates to a flow adjusting mechanism of a die head of a coater and a working method thereof.

### BACKGROUND

A slot coating technology is a technology that presses a coating solution out along a slit of a die head and transfers the coating solution to a moving substrate under a certain pressure, has the characteristics of fast coating, good film uniformity and wide coating window, and is widely used in the coating of lithium-ion battery electrodes.

The current slit extrusion coating die head implements the slit gap adjustment process mainly through three methods: a bolt adjustment method, a micrometer caliper adjustment method or a motor adjustment method. The micrometer adjustment method or the motor adjustment method is to use a rigid coupling to rigidly connect a micrometer head to an adjustment block, and adjust and control the slit gap by turning the micrometer head or controlling the rotation of a motor.

The bolt adjustment method refers to a method of applying an action force to a lip of an upper die or a lip of a lower die by bolt tightening to deform the lip of the upper die or the lip of the lower die, thereby changing the slit gap between the upper die and the lower die. The bolt adjustment method has an apparent effect in the early stage of equipment use, however, after a period of use, the adjustment by using the bolt adjustment method is difficult due to the deformation and failure of the lips. Moreover, the coating process cannot be quickly adjusted and the slit gap cannot be precisely controlled due to defects such as bolt thread wear, deformation, and stagnation. Above all the bolt adjustment method has a hysteresis problem due to the heave reliance on the experience of the operator.

The micrometer caliper adjustment method refers to a method of using a structure similar to a micrometer caliper. An extension rod of the micrometer caliper is connected to a connecting rod through a coupling, and the connecting rod is connected to an adjusting piece. The adjusting piece is controlled to rise or fall by an operator turning the micrometer head of the micrometer caliper, thereby changing the slit gap between the upper die and the lower die. With a scale value displayed, the micrometer caliper adjustment may have a high accuracy in adjusting and controlling the slit gap; however the micrometer caliper adjustment method also has the hysteresis problem and a risk of surface density control failure due to the heave reliance on the experience of the operator.

### Technical issue

The motor adjustment method refers to a method of connecting an output end of a motor to an adjusting piece through a coupling and a connecting rod. The motor automatically adjusts the slit gap through a feedback signal from the system monitoring the surface density data, the adjustment and control is quick, and the adjustment accuracy depends on a closed-loop control of the feedback signal. Due to the crawling phenomenon of the motor in high-resolution control, stroke error and low response speed occur, which is not conducive to the optimal control of the uniformity of coating surface density; and due to the larger size of the motor, a larger size of the corresponding adjustment block occurs, and in turn the resolution of the slit adjustment is degraded.

### Technical solution

In the present invention, improvements are made for the issues existing in the conventional technology described above, that is, the technical issue to be addressed by the present invention is to provide a flow adjusting mechanism of a die head of a coater and a working method thereof, which has a reasonable design and can not only effectively improve the flow adjusting accuracy and adjusting efficiency but also achieve a stable coating quality.

In order to achieve the above objective, the technical solution adopted by the present invention is as follows. A flow adjusting mechanism of a die head of a coater includes a coarse adjustment mechanism, a fine adjustment mechanism and a flow chocking block which are sequentially arranged from top to bottom. The flow chocking block is arranged above a coating slit, a central part of a top surface of the flow chocking block is vertically provided with an adjustment rod. The fine adjustment mechanism is connected between the coarse adjustment mechanism and the adjustment rod.

Optionally, the fine adjustment mechanism includes a piezoelectric actuator arranged vertically, and an actuating end of the piezoelectric actuator abuts against a central portion of a top surface of the adjustment rod. The coarse adjustment mechanism includes a first fixed seat, where a differential screw assembly is vertically installed on the first fixed seat, and a moving end of the differential screw assembly is connected to an upper end of the piezoelectric actuator.

Optionally, the differential screw assembly includes a differential screw rod and a moving shaft that are both vertically arranged, and the differential screw rod is sequentially provided with from top to bottom a first threaded segment and a second threaded segment which have a same rotational direction, the first threaded segment has a thread lead larger than a thread lead of the second threaded segment, and the first threaded segment is threadedly connected to the first fixed seat. The second threaded segment is threadedly connected to an upper end of the moving shaft, the moving shaft is vertically slidingly fitted with the first fixed seat, and a lower end of the moving shaft is threadedly connected to the upper end of the piezoelectric actuator.

Optionally, a lower end of the first fixed seat is threadedly connected to a stop bolt that is arranged transversely and configured to lock the moving shaft, an inverted L-shaped position-limiting block is fixed on the side of the first fixed seat, where a horizontal edge of the position-limiting block is located at a side above the differential screw rod to limit the position of the differential screw rod.

Optionally, an upper end of the adjustment rod is configured with a rebound mechanism configured to drive the adjustment rod to move upward, and the rebound mechanism includes a second fixed seat, the adjustment rod is slidingly fitted with the second fixed seat through a vertical guide member, a press plate connected to the adjustment rod is arranged above the second fixed seat, and a compressed elastic member is arranged vertically between the press plate and the second fixed seat and abuts against the press plate and the second fixed seat.

Optionally, the press plate is movably sleeved on an outside of the adjustment rod, and a top surface of the press plate abuts against an adjustment nut threadedly connected to the adjustment rod, and a bottom surface of the press plate abuts against the top of the compressed elastic member.

Optionally, a contact displacement sensor is vertically provided on a side of the piezoelectric actuator, and a detection end of the contact displacement sensor abuts against a top surface of the press plate.

Optionally, the fine adjustment mechanism further includes an installation frame configured to be fixed on the upper die of the coater, where a guide plate horizontally arranged is fixedly connected to a lower end of the installation frame, and the piezoelectric actuator and the contact displacement sensor are each vertically slidably connected to the guide plate. The first fixed seat is fixed on the top of the installation frame.

Optionally, a horizontal section of the flow chocking block is in a non-rectangular shape, and a left side surface and a right side surface of the flow chocking block are each inclined relative to a longitudinal axis of the flow chocking block.

Another technical solution adopted by the present invention is a working method of the flow adjusting mechanism of the die head of the coater. during working, in response to an downward moving requirement of the flow chocking block, turning the differential screw rod to allow the differential screw rod to drive, through the moving shaft, the piezoelectric actuator, the adjustment rod and the flow chocking block to move downward synchronously to achieve coarse adjustment, and increasing a voltage output to the piezoelectric actuator to stretch the piezoelectric actuator to push, through the adjustment rod, the flow chocking block to continue moving downward to achieve fine adjustment; and in response to an upward moving requirement of the flow chocking block, reversely turning the differential screw rod or decreasing the voltage output to the piezoelectric actuator to allow the compressed elastic member to push, through an elastic force of the compressed elastic member, the adjustment rod and the fluid chocking block to move upward.

### Beneficial effect

Compared with the conventional technology, the present invention achieves effects as follows. A coarse adjustment is achieved by using the differential screw structure and a fine adjustment is achieved by using the piezoelectric actuator, so that the present invention is reasonable in design because of the combination of the coarse adjustment and the fine adjustment, such that the flow adjusting accuracy and adjusting efficiency are effectively improved, the coating quality is also stable, and the coating uniformity is improved.

### BRIEF DESCRIPTION OF DRAWINGS

FIG. 1 is a schematic front sectional view showing the structure of an embodiment of the present invention;
FIG. 2 is a schematic perspective view showing the structure of an embodiment of the present invention;
FIG. 3 is a schematic front sectional view showing the structure of a coarse adjustment mechanism in an embodiment of the present invention;
FIG. 4 is a schematic front sectional view showing the structure of a rebound mechanism in an embodiment of the present invention;
FIG. 5 is a schematic perspective view showing the structure of a rebound mechanism in an embodiment of the present invention;
FIG. 6 is a schematic horizontal cross-sectional view of a flow chocking block in an embodiment of the present invention;
FIG. 7 is a schematic perspective view showing the structure of a flow chocking block in an embodiment of the present invention; and
FIG. 8 is a schematic structural view showing the cooperation of multiple flow chocking blocks in an embodiment of the present invention.

Reference numerals in the drawings:
1-upper die;
2-lower die;
3 -spacer;
4-coarse adjustment mechanism;
5-fine adjustment mechanism;
6-flow chocking block;
601-left side surface;
602-right side surface;
603-longitudinal axis;
604-slit;
605-front side surface;
606-bottom surface;
7-adjustment rod;
8-piezoelectric actuator;
9-actuating end;
10-first fixed seat;
11-differential screw rod;
12-moving shaft;
13-first threaded segment;
14-second threaded segment;
15-first vertical threaded hole;
16-vertical sliding hole;
17-second vertical threaded hole;
18-position-limiting step;
19-horizontal threaded hole;
20-stop bolt;
21-position-limiting block;
22-operating hole;
23-second fixed seat;
24-vertical guide member;
25-press plate;
26-compressed elastic member;
27-vertical through hole
28-adjustment nut;
29-accommodating recess;
30-contact displacement sensor;
31-installation frame;
32-guide plate.

### DETAILED DESCRIPTION

The present invention is described in further detail hereinafter in conjunction with the drawings and embodiments.

In describing the present invention, it should be understood that the orientations or positional relationships indicated by the terms "longitudinal", "transverse", "upper", "lower", "front", "rear", "left", "right", "vertical", "horizontal", "top", "bottom", "inner", "outer", etc. are based on the orientations or positional relationships shown in the drawings, and are only for the convenience of describing the present invention, rather than indicating or implying that a referenced device or element must have a particular orientation, be constructed and operated in a particular orientation, and therefore should not be construed as limiting the present invention.

In this embodiment, the flow adjusting mechanism is configured to adjust output of a coating liquid of a coater. The coater includes an upper die 1 and a lower die 2 which are matched with each other, and a spacer 3 is sandwiched between the upper die and the lower die. The thickness of the spacer is the width of a coating slit, a front end of the spacer is provided with a coating opening for discharging, and an adjustment slot extending in a coating width direction is provided above the coating opening.

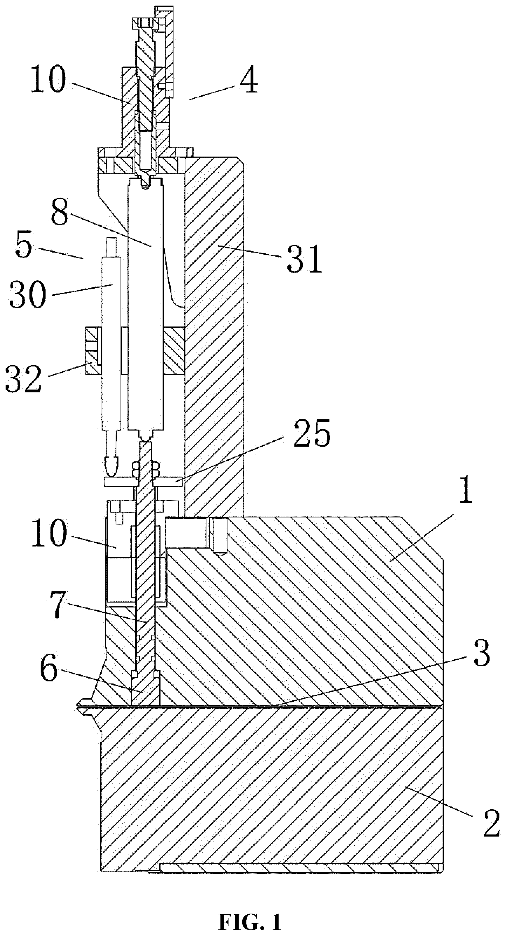

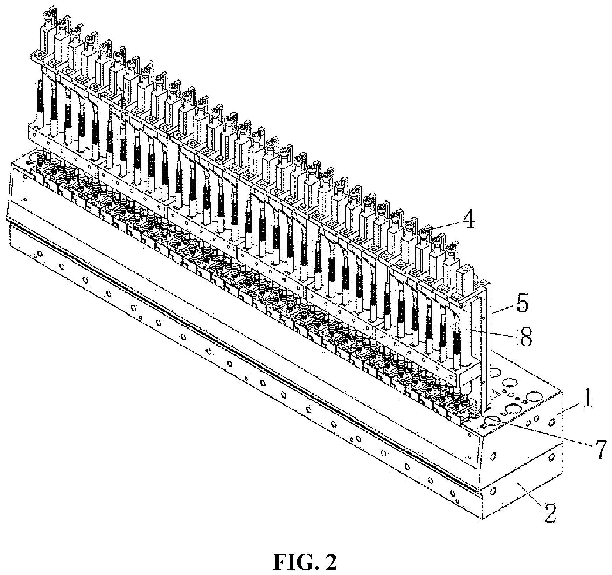

As shown in FIG. 1 to FIG. 8, a flow adjusting mechanism of a die head of a coater according to the present invention is arranged on the upper die of the coater, and it includes a coarse adjustment mechanism 4, a fine adjustment mechanism 5 and a flow chocking block 6 which are arranged sequentially from top to bottom. The flow chocking block 6 is arranged above the coating slit and is arranged in the adjustment slot of the upper die, a central part of a top surface of the flow chocking block 6 is vertically provided with an adjustment rod 7; and the fine adjustment mechanism 5 is connected between the coarse adjustment mechanism 4 and the adjustment rod 7. In use, the coarse adjustment mechanism drives the fine adjustment mechanism, the adjustment rod and the flow chocking block to move vertically synchronously to achieve coarse adjustment. After the coarse adjustment mechanism finishes working, the fine adjustment mechanism drives the adjustment rod and the flow chocking block to move vertically synchronously to achieve fine adjustment. The combination of coarse adjustment and fine adjustment can effectively improve the accuracy of flow adjustment.

It is to be noted that the flow adjusting mechanism of the die head of the coater can be installed onto the upper die of the coater or be installed onto the lower die of the coater. Being installed onto the upper die of the coater is used as an example in this embodiment. If the entire adjustment mechanism is installed onto the lower die, the flow chocking block is arranged in the lower die, and the specific structure is the same as that being installed in the upper die, thus being installed onto the lower die of the coater is not repeated here.

In this embodiment, the fine adjustment mechanism 5 includes a piezoelectric actuator 8 arranged vertically, and an actuating end 9 of the piezoelectric actuator 8 is in a semispherical shape and abuts against a central portion of a top surface of the adjustment rod 7 to form a point contact. The coarse adjustment mechanism 4 includes a first fixed seat 10 on which a differential screw assembly is vertically installed, and a moving end of the differential screw assembly is connected to an upper end of the piezoelectric actuator 8. The differential screw structure is used to achieve coarse adjustment, and the piezoelectric actuator is used to achieve fine adjustment.

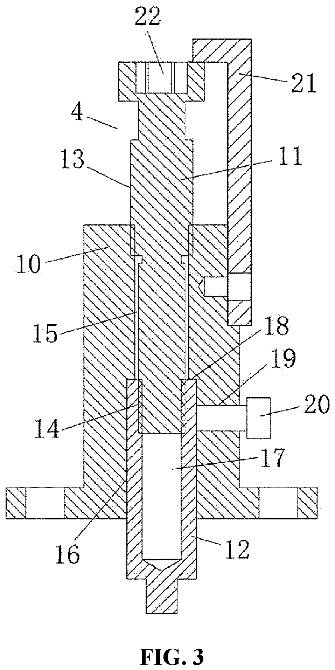

In this embodiment, as shown in FIG. 3, the differential screw assembly includes a differential screw rod 11 and a moving shaft 12 that are both vertically arranged, and the differential screw rod 11 is sequentially provided with from top to bottom a first threaded segment 13 and a second threaded segment 14 which have the same rotational direction. The first threaded segment 13 has a thread lead larger than a thread of the second threaded segment 14, and the first threaded segment 13 is threadedly connected to the first fixed seat 10. The second threaded segment 14 is threadedly connected to an upper end of the moving shaft 12, the moving shaft 12 is vertically slidingly fitted with the first fixed seat 10, and a lower end of the moving shaft 12 is threadedly connected to the upper end of the piezoelectric actuator 8. During working, when it requires a downward moving of the flow chocking block, the differential screw rod 11 is turned, the first threaded segment 13 of the differential screw rod 11 moves downward relative to the first fixed seat 10, and the moving shaft 12 moves upward relative to the second threaded segment 14 of the differential screw rod 11. Threads of different thread pitches are used for meshing, and thread pitch difference is used to convert the circular rotation into a linear motion. In this case, the distance by which the differential screw rod 11 moves downward is combined with the distance by which the moving shaft 12 moves upward, so that moving at a small distance can be achieved, thereby improving the resolution of the coarse adjustment, making the adjustment more accurate, and thus reducing the sensitivity to the rotation angle of the differential screw rod. The turning of the differential screw rod can be performed manually by an operator or automatically by equipment. If the turning is performed by an operator manually, the requirements for the operator are reduced in this case, and a fool-proofing protection is provided to the operator.

It is to be noted that in the differential screw assembly, since the flow chocking block is only slidably fitted with the upper die head of the coater in a vertical direction (that is, it can only move vertically), and the moving shaft is connected to the flow chocking block by the piezoelectric actuator and the adjusting rod, therefore, the moving shaft also only have the degree of freedom of moving in the vertical direction, and does not have the degree of freedom of rotation.

In this embodiment, for the convenience of assembly, a top surface of the first fixed seat 10 is provided with a first vertical threaded hole 15 for being fitted with the first threaded segment 13, and the first fixed seat 10 is provided with a vertical sliding hole 16 below and in communication with the vertical threaded hole 15. The moving shaft 12 can only slide along the vertical sliding hole 16. A top surface of the moving shaft 12 is provided with a second vertical threaded hole 17 for being fitted with the second threaded segment 14.

In this embodiment, in order to limit the upward vertical movement of the moving shaft, a position-limiting step 18 configured to limit the moving shaft is provided between the first vertical threaded hole 15 and the vertical sliding hole 16.

In this embodiment, in order to facilitate the fixing of the moving shaft after moving vertically, a lower end of the first fixed seat 10 is provided with a horizontal threaded hole 19 in communication with the vertical sliding hole 16, a stop bolt 20 is threadedly connected in the horizontal threaded hole 19, and the stop bolt is used to press against an outer wall of the moving shaft to lock the moving shaft so that the moving shaft cannot move along the vertical sliding hole.

In this embodiment, in order to limit the position of the upward movement of the differential screw rod and avoid damage caused by excessive upward movement of the flow chocking block, an inverted L-shaped position-limiting block 21 is fixed on a side of the first fixed seat 10, and a horizontal edge of the position-limiting block 21 is located at a side above the differential screw rod 11 and is arranged to abut against a top surface of the differential screw rod 11 to limit the position of the differential screw rod.

In this embodiment, when the differential screw rod is turned manually by an operator, in order to facilitate the turning of the differential screw rod, the top surface of the differential screw rod 11 is provided with a hexagonal operating hole 22 for being fitted with a hexagonal wrench.

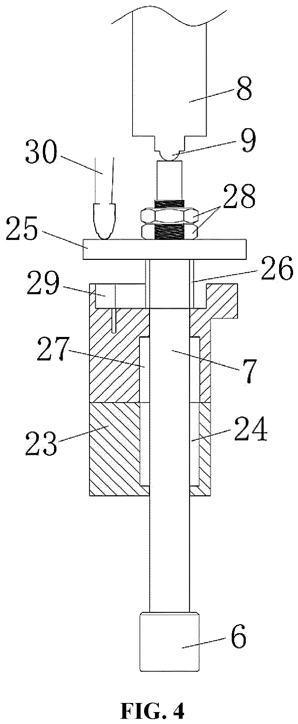

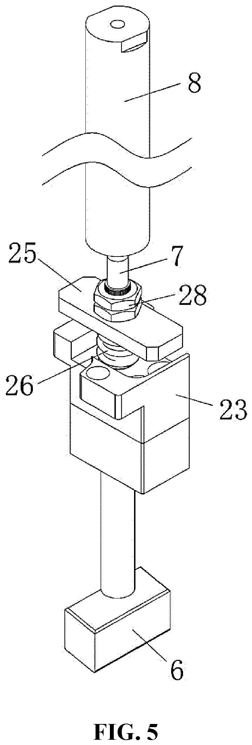

In this embodiment, as shown in FIG. 4 and FIG. 5, in order to facilitate the automatic upward rebound of the adjustment rod, a rebound mechanism configured to drive the adjustment rod to move upward is arranged at an upper end of the adjustment rod 7, and the rebound mechanism includes a second fixed seat 23. The adjustment rod 7 is slidingly fitted with the second fixed seat 23 through a vertical guide member 24, a press plate 25 connected to the adjustment rod 7 is arranged above the second fixed seat 23, and a compressed elastic member 26 is arranged vertically between the press plate 25 and the second fixed seat 23 and abuts against the press plate 25 and the second fixed seat 23. The elastic force is used to mechanically and automatically rebound the flow chocking block, and the vertical movement of the flow chocking block is precisely guided by the guide member, which can realize the smooth automatic rebound of the flow chocking block, reduce the lateral error, and prevent the jamming phenomenon.

In this embodiment, the second fixed seat 23 is provided with a vertical through hole 27 to facilitate the vertically passing through of the adjustment rod 7, and the vertical through hole is a stepped hole structure with a small diameter at both ends and a large diameter in the middle. The vertical guide member 24 is vertically installed in a middle hole portion of the vertical through hole.

In this embodiment, the vertical guide member 24 can improve the vertical guiding accuracy and reduce the lateral movement. The vertical guide member 24 can be a steel ball bush, which is set on an outer side of the adjustment rod 7. It is to be noted that the steel ball bushing is a conventional mature product, which is also called a steel ball linear bearing, and its specific structure is not repeated here. The steel ball bushing of high precision is utilized to form a precise fit with the adjustment rod of the flow chocking block, and the fit accuracy can reach the micron level. The steel ball bushing restricts the degree of freedom in lateral direction of the flow chocking block, which can ensure that the flow chocking block can only move along a predetermined direction (for example vertical direction).

In this embodiment, the upper end of the adjustment rod 7 has a threaded segment, the press plate 25 is movably sleeved on the outside of the threaded segment of the adjustment rod 7, and a top surface of the press plate 25 abuts against an adjustment nut 28 threadedly connected to the threaded segment of the adjustment rod 7. Two adjustment nuts 28 are provided, and a bottom surface of the press plate 25 abuts against the top of the compressed elastic member 26. The press plate is supported by the cooperation of the compressed elastic member and the adjustment nuts. Since the compressed elastic member always generates an upward force on the press plate, the press plate transmits this force to the adjustment rod through the compressed elastic member. After the adjustment rod moves down, the force can push the adjustment lever to automatically rebound and return upwards. By turning the adjustment nut, the adjustment nut drives the press plate to move up and down to adjust the compression degree of the compressed elastic member, and further adjust the upward elastic force of the compressed elastic member.

In this embodiment, an accommodating recess 29 is provided on the top surface of the second fixed seat 23, and the bottom of the compressed elastic member 26 abuts against a bottom surface of the accommodating recess.

In this embodiment, the compressed elastic member 26 may be, for example, a compression spring, and the compression spring is sleeved on the outside of the adjustment rod.

In this embodiment, in order to detect a vertical displacement generated by the piezoelectric actuator 8 driving the flow chocking block, a contact displacement sensor 30 is vertically provided on the side of the piezoelectric actuator 8. A detection end of the contact displacement sensor 30 abuts against the top surface of the press plate 25. The press plate moves synchronously with the adjustment rod; therefore, the movement of the flow chocking block and the adjustment rod is detected by the contact displacement sensor through the pressing plate. Due to the use of the contact displacement sensor, micron-level displacements can be detected.

In this embodiment, the fine adjustment mechanism further includes an installation frame 31 configured to be fixed on the upper die 1 of the coater. A guide plate 32 horizontally arranged is fixedly connected to a lower end of the installation frame 31. The piezoelectric actuator and the contact displacement sensor are vertically slidably connected to the guide plate 32. The first fixed seat 10 is fixed on the top of the installation frame 31.

In this embodiment, the actuating end 9 of the piezoelectric actuator 8 forms a point contact with a middle portion of the top surface of the adjustment rod 7, that is, the piezoelectric actuator and the adjustment rod are structures separate from each other rather than being rigidly connected. The deformation of the piezoelectric actuator generated after the piezoelectric actuator is energized is used to drive the adjustment rod to move vertically, and then play a role in adjusting the flow chocking block. The flow chocking block uses the elastic force of the elastic member when being compressed to automatically rebound mechanically, which cooperates with the piezoelectric actuator to make the vertical movement of the flow chocking block have an automatic deviation correction effect, and advanced algorithms may be combined therewith to achieve a high-frequency response.

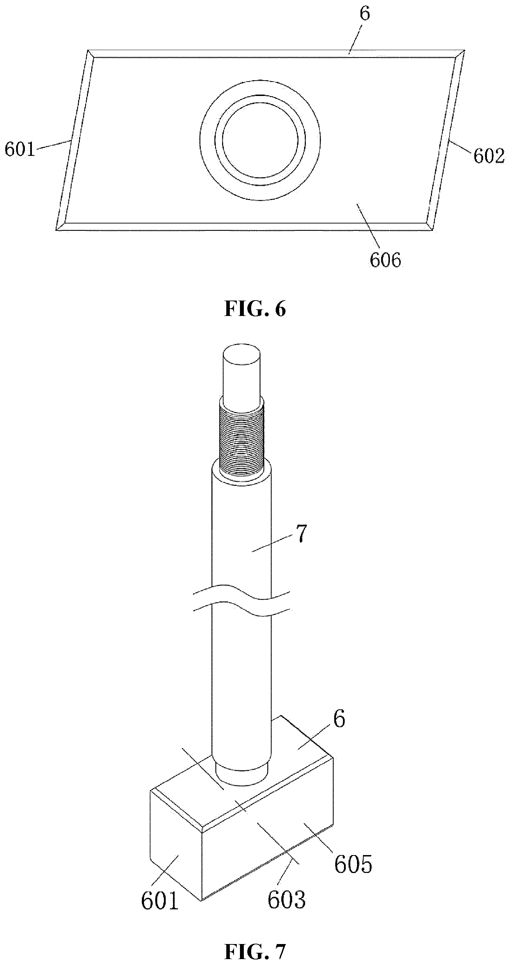

In this embodiment, as shown in FIG. 6 and FIG. 7, a horizontal section of the flow chocking block 6 is in a non-rectangular shape, a bottom surface 606 of the flow chocking block is a plane, and a left side surface 601 and a right side surface 602 of the flow chocking block 6 are inclined relative to a longitudinal axis 603 of the flow chocking block 6. By designing the horizontal section of the flow chocking block to be non-rectangular, when two adjacent flow chocking blocks cooperate, a slit between the two flow chocking blocks is inclined relative to the longitudinal direction, and in this case the slit does not directly pass through in the longitudinal direction (the flow direction of the liquid). In this case, the coating liquid cannot pass through the slit between the two flow chocking blocks directly and quickly in the longitudinal direction, which effectively reduces the flow rate of the coating liquid, reduces the straight-through distance of the fluid, and avoids straight flushing, significantly reduces the risk of causing bulged ribs when coating.

In this embodiment, for the convenience of manufacture, the left side surface 601 and the right side surface 602 of the flow chocking block 6 are both planes. It is be noted that the left side surface and the right side surface of the flow chocking block are configured to cooperate with the adjacent flow chocking blocks to form the slits 604 through which the coating liquid passes, as long as the side surfaces can be inclined relative to the longitudinal axis of the flow chocking block, it is just possible to prevent the coating liquid from directly and rapidly flow longitudinally, and the side surface can also be embodied as surfaces of other shapes besides a flat surface, such as a wavy surface, or other irregular-shaped surfaces.

In this embodiment, for the convenience of manufacture, a front side surface 605 and a rear side surface of the flow chocking block 6 are also flat surfaces, that is, the horizontal section of the flow chocking block is in the shape of a quadrilateral. Preferably, the horizontal section of the flow chocking block is in the shape of a parallelogram. According to the simulation analysis results, the slits between the flow chocking blocks with a parallelogram-shaped horizontal section have less impact on the fluid than the slits between the flow chocking blocks with a rectangular horizontal section, thereby effectively reducing the risk of forming bulged ribs.

In this embodiment, the flow chocking block is integrally manufactured.

In this embodiment, the entire flow chocking block is in the shape of a rhombus.

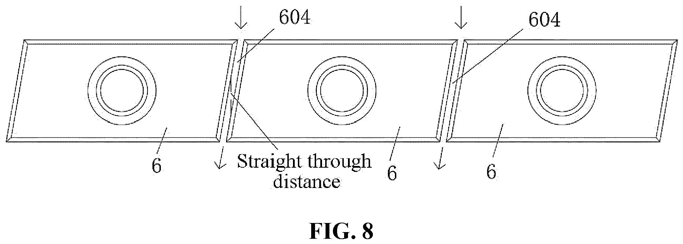

In this embodiment, when in use, the horizontal cross-section of the flow chocking block is in the shape of a parallelogram, and the left side surface and the right side surface of the flow chocking block are sloped (that is, inclined relative to the longitudinal axis of the flow chocking block), when several flow chocking blocks are distributed side by side in the horizontal direction, as shown in FIG. 8, at this time, the slits between adjacent flow chocking blocks are inclined relative to the longitudinal axis of the flow chocking blocks, and the coating liquid cannot directly rapidly pass through the inclined slits vertically. The straight-through distance of the coating liquid is smaller than the width of the flow chocking block, so as to reduce the straight-through distance, so that the outflow speed of the coating liquid is reduced, thereby avoiding straight-flushing, and effectively reducing the risk of forming bulged ribs.

In this embodiment, the piezoelectric actuator is a conventional technology, and its structure is cylindrical. By increasing or decreasing a voltage output to the piezoelectric actuator, the length of the piezoelectric actuator will change. The greater the voltage, the greater the elongation, and its specific structure and control principle are not repeated here. The piezoelectric actuator of the present invention is directly driven, and is stretched or shortened by increasing or decreasing the voltage output to the piezoelectric actuator, the expansion and contraction amount is used to push the flow chocking block to move up or down slightly to realize fine adjustment, and the adjustment accuracy can reach the micron level and a quick response is realized. The direct driven piezoelectric actuator has a high rigidity and a stable output, and can be well cooperated with other structures and has a high compatibility.

The specific implementation process is as follows. During working, the differential screw rod 11 is turned, the first threaded segment 13 of the differential screw rod 11 moves downward relative to the first fixed seat 10, and the moving shaft 12 moves upward relative to the second threaded segment 14 of the differential screw rod 11. Threads of different thread pitches are used for meshing, and thread pitch difference is used to convert the circular rotation into a linear motion. In this case, the distance by which the differential screw rod 11 moves downward is combined with the distance by which the moving shaft 12 moves upward, so that move at a small distance can be achieved, thereby improving the resolution of the adjustment, making the adjustment more accurate. At this time, the differential screw rod 11 drives, through the moving shaft 12, the piezoelectric actuator 8, the adjustment rod 7 and the flow chocking block 6 to move downward synchronously to achieve coarse adjustment; and after that, the voltage output to the piezoelectric actuator 8 is increased, and the piezoelectric actuator 8 stretches and pushes the flow chocking block 6 through the adjustment rod 7 to continue to move downward to achieve fine adjustment. When it requires the flow chocking block to move upward, the differential screw rod 11 is turned reversely or the voltage output to the piezoelectric actuator 8 is decreased, and the compressed elastic member pushes by its elastic force the adjustment rod 7 and the fluid chocking block 6 to move upward, to achieve the upward movement. Since the compression spring is always in a compressed state, the middle portion of the top surface of the adjustment rod 7 always abuts against the actuating end 9 of the piezoelectric actuator 8 to form a point contact under the action of elastic force even when it is not working. In the whole process, the differential screw structure drives the flow chocking block 6 to move vertically for a large distance, this is the coarse adjustment, and then the voltage output to the piezoelectric actuator 8 is increased, and the micron-level elongation generated by the increased voltage is utilized to push the flow chocking block 6 to move, this is the fine adjustment, so that the vertical adjustment of the flow chocking block 6 can reach micron level accuracy. This combination of coarse adjustment and fine adjustment significantly improves the adjustment accuracy, moreover, the steel ball bushing is utilized to guide the vertical movement of the adjustment rod precisely, thus, the error of the lateral deviation of the adjustment rod when moving is small, and the adjustment rod is subjected to a small friction force, and it is not apt to be stuck due to high resistance. The elastic force is utilized to achieve the automatic and smooth rebound of the flow chocking block, which cooperates with the piezoelectric actuator, and is combined with advanced algorithms to achieve a high-frequency response. When in use, it is also possible to carry out fine adjustment first to see if it meets the adjustment requirements, and if it meets the adjustment requirements, there is no need to perform coarse adjustment; and if it does not meet the requirements, the fine adjustment is combined with the coarse adjustment.

It is to be noted that the cost of the piezoelectric actuator is relatively high. If it is only the piezoelectric actuator that is used for flow adjustment, in order to achieve a larger adjustment range, it is necessary to use a larger piezoelectric actuator, and the entire production cost is very high in this case. In the present invention, the differential screw structure is used as a coarse adjustment mechanism to achieve a wide range of adjustment, and further the coarse adjustment is combined with the high-accuracy fine adjustment of the piezoelectric actuator, so that there is no need to use a large-sized piezoelectric actuator, which significantly saves cost of production.

The present invention has advantages as follows. the accuracy of flow adjustment is effectively improved, and moreover, the fine adjustment can respond quickly, an automatic deviation correction effect is achieved in the adjustment process, and advanced algorithms may be combined therewith to achieve a high-frequency response; and the impact causing the sudden change of fluid flow rate during coating is small, the risk of forming bulged ribs can be effectively reduced, and the coating is more stable and uniform. The adjustment mechanism does not need to use a motor, so the size of the flow chocking block is small, the overall structure is compact, and the resolution of the slit adjustment is improved.

If the present invention discloses or relates to parts or structural parts that are fixedly connected to each other, unless otherwise stated, the fixed connection can be understood as a detachable fixed connection (for example, using bolts or screws), or it can also be understood as: a non-detachable fixed connection (such as riveting, welding), of course, the mutual fixed connection can also be replaced by an integrated structure (for example, manufactured into one piece by casting process) (except that the integral forming process cannot be adopted obviously).

In addition, unless otherwise stated, the implications of terms used in any of the technical solutions disclosed in the present invention to indicate positional relationships or shapes include states or shapes that are like, similar to or close to the indicated positional relationships or shapes.

Any component according to the present invention can be formed by assembling multiple individual components, or can be a single component manufactured by integral forming process.

It is to be noted that the above embodiments are only intended to illustrate the technical solutions of the present invention rather than limiting thereto; although the present invention has been described in detail with reference to the preferred embodiments, the person of ordinary skill in the art should understand that: the embodiments of the present invention can still be modified or part of technical features can be substituted equivalently without departing from the concept of the technical solution of the present invention, and the modification and equivalent substitutions should be included in the scope of the technical solution claimed in the present invention.

## Claims

1. A flow adjusting mechanism of a die head of a coater, comprising:
a coarse adjustment mechanism, a fine adjustment mechanism and a flow chocking block which are sequentially arranged from top to bottom, wherein the flow chocking block is arranged above a coating slit, a central part of a top surface of the flow chocking block is vertically provided with an adjustment rod; and the fine adjustment mechanism is connected between the coarse adjustment mechanism and the adjustment rod.

2. The flow adjusting mechanism of the die head of the coater according to claim 1, wherein,
The fine adjustment mechanism comprises a piezoelectric actuator arranged vertically, and an actuating end of the piezoelectric actuator abuts against a central portion of a top surface of the adjustment rod; and
the coarse adjustment mechanism comprises a first fixed seat, wherein a differential screw assembly is vertically installed on the first fixed seat, and a moving end of the differential screw assembly is connected to an upper end of the piezoelectric actuator.

3. The flow adjusting mechanism of the die head of the coater according to claim 2, wherein the differential screw assembly comprises a differential screw rod and a moving shaft that are both vertically arranged, and the differential screw rod is sequentially provided with from top to bottom a first threaded segment and a second threaded segment which have a same rotational direction, the first threaded segment has a thread lead larger than a thread lead of the second threaded segment, and the first threaded segment is threadedly connected to the first fixed seat; and the second threaded segment is threadedly connected to an upper end of the moving shaft, the moving shaft is vertically slidingly fitted with the first fixed seat, and a lower end of the moving shaft is threadedly connected to the upper end of the piezoelectric actuator.

4. The flow adjusting mechanism of the die head of the coater according to claim 3, wherein,
a lower end of the first fixed seat is threadedly connected to a stop bolt that is arranged transversely and configured to lock the moving shaft,
an inverted L-shaped position-limiting block is fixed on the side of the first fixed seat, wherein a horizontal edge of the position-limiting block is located at a side above the differential screw rod to limit the position of the differential screw rod.

5. The flow adjusting mechanism of the die head of the coater according to claim 1 or 2, wherein an upper end of the adjustment rod is configured with a rebound mechanism configured to drive the adjustment rod to move upward, and the rebound mechanism comprises a second fixed seat, the adjustment rod is slidingly fitted with the second fixed seat through a vertical guide member, a press plate connected to the adjustment rod is arranged above the second fixed seat, and a compressed elastic member is arranged vertically between the press plate and the second fixed seat and abuts against the press plate and the second fixed seat.

6. The flow adjusting mechanism of the die head of the coater according to claim 5, wherein the press plate is movably sleeved on an outside of the adjustment rod, and a top surface of the press plate abuts against an adjustment nut threadedly connected to the adjustment rod, and a bottom surface of the press plate abuts against a top of the compressed elastic member.

7. The flow adjusting mechanism of the die head of the coater according to claim 5, wherein a contact displacement sensor is vertically provided on a side of the piezoelectric actuator, and a detection end of the contact displacement sensor abuts against a top surface of the press plate.

8. The flow adjusting mechanism of the die head of the coater according to claim 5, wherein the fine adjustment mechanism further comprises an installation frame configured to be fixed on the upper die of the coater, a guide plate horizontally arranged is fixedly connected to a lower end of the installation frame, and the piezoelectric actuator and the contact displacement sensor are each vertically slidably connected to the guide plate; and the first fixed seat is fixed on the top of the installation frame.

9. The flow adjusting mechanism of the die head of the coater according to claim 1, wherein a horizontal section of the flow chocking block is in a non-rectangular shape, and a left side surface and a right side surface of the flow chocking block are each inclined relative to a longitudinal axis of the flow chocking block.

10. A working method of a flow adjusting mechanism of a die head of a coater, applied to the flow adjusting mechanism of the die head of the coater according to any one of claims 1 to 9, comprising:
during working, in response to an downward moving requirement of the flow chocking block, turning the differential screw rod to allow the differential screw rod to drive, though the moving shaft, the piezoelectric actuator, the adjustment rod and the flow chocking block to move downward synchronously to achieve coarse adjustment; and increasing a voltage output to the piezoelectric actuator to stretch the piezoelectric actuator to push, through the adjustment rod, the flow chocking block to continue moving downward to achieve fine adjustment; and
in response to an upward moving requirement of the flow chocking block, reversely turning the differential screw rod or decreasing the voltage output to the piezoelectric actuator to allow the compressed elastic member to push, through an elastic force of the compressed elastic member, the adjustment rod and the fluid chocking block to move upward.
